(19) **Europäisches Patentamt**
**European Patent Office**
**Office européen des brevets**

(11) **EP 1 583 228 B1**

(12) **EUROPEAN PATENT SPECIFICATION**

(45) Date of publication and mention
of the grant of the patent:
**17.08.2011 Bulletin 2011/33**

(51) Int Cl.:
*H03F 1/32* *(2006.01)*    *H03F 1/02* *(2006.01)*

(21) Application number: **05011980.9**

(22) Date of filing: **13.12.2002**

(54) **Composite power amplifier**

Zusammengesetzter Listungsverstärker

Amplificateur de puissance composite

(84) Designated Contracting States:
**AT BE BG CH CY CZ DE DK EE ES FI FR GB GR
IE IT LI LU MC NL PT SE SI SK TR**

(30) Priority: **16.01.2002 SE 0200127**

(43) Date of publication of application:
**05.10.2005 Bulletin 2005/40**

(62) Document number(s) of the earlier application(s) in
accordance with Art. 76 EPC:
**02792144.4 / 1 470 635**

(73) Proprietor: **Telefonaktiebolaget L M Ericsson
(publ)
164 83 Stockholm (SE)**

(72) Inventor: **Hellberg, Richard
14147 Huddinge (SE)**

(74) Representative: **Kühn, Friedrich Heinrich et al
Ericsson AB
Patent Unit Radio Networks
Torshamnsgatan 23
164 80 Stockholm (SE)**

(56) References cited:
**WO-A-01/91282     WO-A-93/18590**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 1 583 228 B1

**Description**

TECHNICAL FIELD

The present invention relates generally to composite power amplifiers.

BACKGROUND

In many wireless communications systems, the power amplifier (PA) in the transmitter is required to be very linear, in addition to being able to simultaneously amplify many radio channels (frequencies) spread across a fairly wide bandwidth. It also has to do this efficiently, in order to reduce power consumption and need for cooling, and to increase its longevity. High linearity is required since nonlinear amplifiers would cause leakage of interfering signal energy between channels.

The amplitude probability density of a mix of sufficiently many independent radio frequency (RF) channels, or of a multi-user CDMA (Code Division Multiple Access) signal, tends to be close to a Rayleigh distribution having a large peak-to-average power ratio. Since a conventional RF power amplifier generally has an efficiency proportional to its output amplitude, its average efficiency is very low for such signals.

In response to the low efficiency of conventional linear power amplifiers, many methods have been proposed. Two of the most promising are the Chireix outphasing method [1] and the Doherty method [2]. Since their publication in 1935 and 1936, respectively, the theories, implementations and improvements of these two types of RF amplifier systems have remained separate from each other. The operation of the Chireix amplifier has thus been described in terms of constant-voltage operation of the constituent amplifiers, with outphasing of the constant-amplitude phasors as the method for obtaining amplitude modulation. The efficiency increasing action of the Doherty amplifier has been described in terms of (dynamic) impedance modulation of the load or, equivalently, variable load distribution.

At least two problems have been identified in these previously known composite power amplifiers.

Firstly, the output network of Chireix and Doherty amplifiers must be tuned with high precision to have the right properties at the desired frequency. This is a costly and time-consuming process, especially when large quantities of transmitters are to be produced.

Secondly, neither the Chireix nor the Doherty amplifier is suited for operation over multiple, relatively closely spaced bands (such as 1800/1900/2100 MHz).

In light of the problems just described, there is a need for an amplifier that can operate without excessive tuning of the output network. A need can also be identified for an amplifier that can function over multiple bands without redesign or retuning.

SUMMARY

An object of the present invention is an improved Chireix type composite amplifier.

This object is achieved in accordance with the attached claim.

The modified output network used in the new Chireix type composite amplifier eliminates the need for compensating reactances used in the prior art.

BRIEF DESCRIPTION OF THE DRAWINGS

The invention, together with further objects and advantages thereof, may best be understood by making reference to the following description taken together with the accompanying drawings, in which:

Fig. 1 is a block diagram of a typical prior art Chireix amplifier;
Fig. 2 is a block diagram illustrating a Chireix output network that has been modified in accordance with the present invention;
Fig. 3 is a diagram illustrating the relationship between the amplitudes of the linear/nonlinear output current components and the output voltage for a conventional Chireix amplifier;
Fig. 4 is a diagram illustrating the relationship between the linear/ nonlinear output current components and the output voltage for a Chireix amplifier that has been modified in accordance with the present invention;
Fig. 5 is a block diagram of an exemplary embodiment of a Chireix amplifier in accordance with the present invention;
Fig. 6 is a model of the modified Chireix amplifier output network;

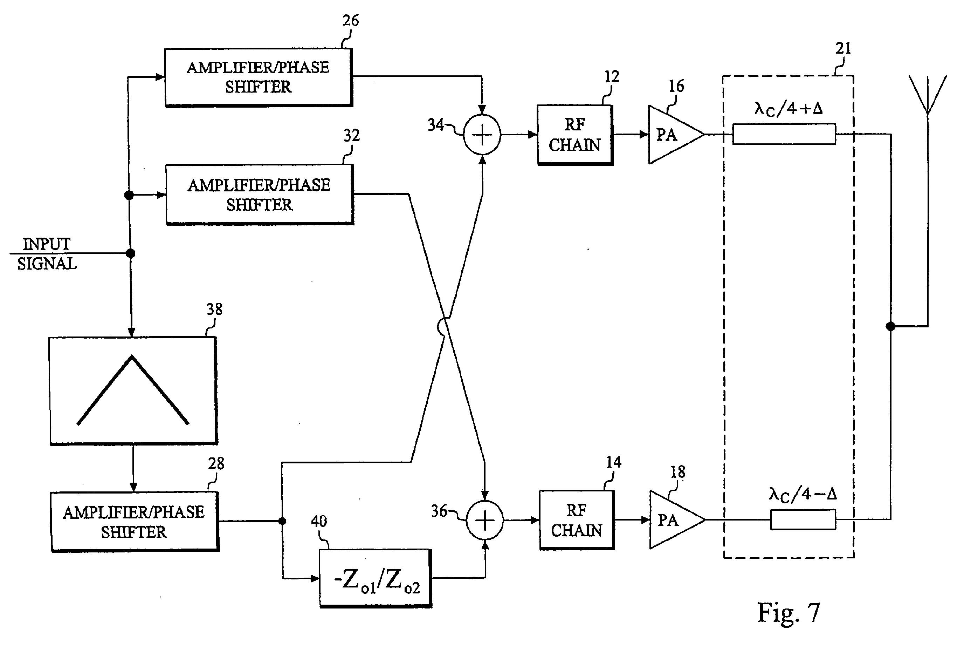

Fig. 7 is a block diagram of another exemplary embodiment of a Chireix amplifier in accordance with the present invention;
Fig. 8 is a block diagram of an exemplary embodiment of a composite amplifier in accordance with the present invention; and
Fig. 9 is a diagram illustrating the efficiency of a composite amplifier in accordance with the present invention for different modes of operation.

## DETAILED DESCRIPTION

In the following description the same reference designations will be used for the same or similar elements throughout the figures of the drawings.

Furthermore, although they are not identical, the output networks of both Chireix and LINC amplifiers will be denoted Chireix type output network or combiner.

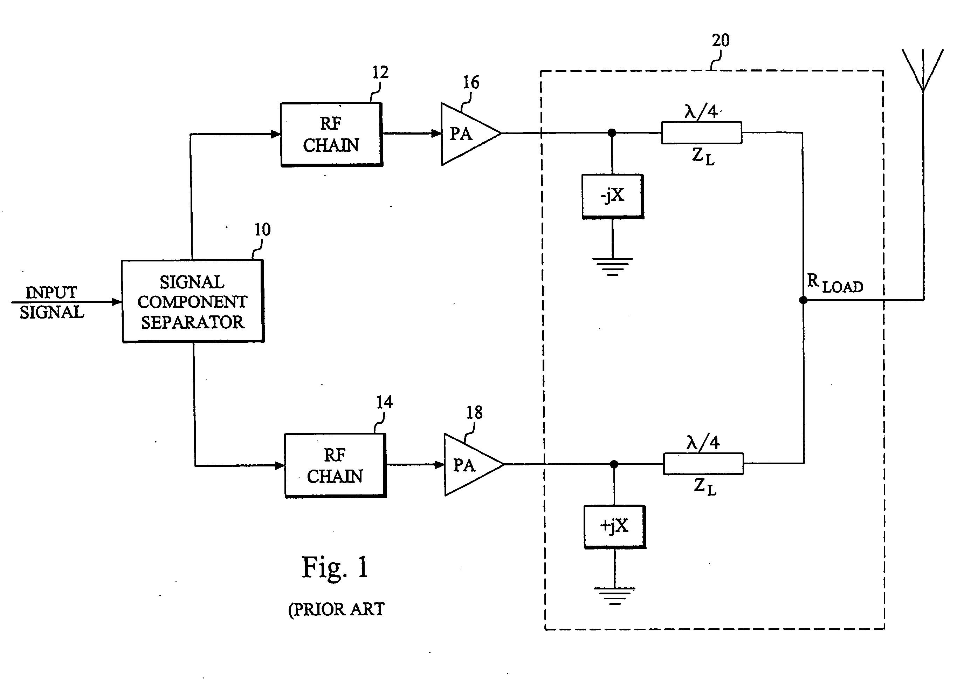

Fig. 1 is a block diagram of a typical prior art Chireix amplifier. The term "outphasing", which is the key method in Chireix and LINC amplifiers, generally means the method of obtaining amplitude modulation by combining two phase-modulated constant-amplitude signals produced in a signal component separator 10. After up-conversion and amplification through RF chains 12, 14 (mixers, filters, amplifiers) and power amplifiers 16, 18, the outphased signals are combined to form an amplified linear signal in a Chireix type output network 20. The phases of these constant-amplitude outphased signals are chosen so that the result from their vector-summation yields the desired amplitude. Output network 20 includes two quarter-wave lines $\lambda/4$ and two compensating reactances $+jX$ and $-jX$, which are used to extend the region of high efficiency to include lower output power levels. In [3, 4] the efficiency of Chireix systems is analyzed. In [5, 6, 7] methods to overcome nonlinearity due to gain and phase imbalances are described. The Chireix method has also been used in broadcast transmitters under the trademark Ampliphase [6, 7].

An advantage of the Chireix amplifier is the ability to change the efficiency curve to suit different peak-to-average power ratios, by changing the size (X) of the reactances. The peak output power is equally divided between the amplifiers irrespective of this adjustment, which means that equal size (capacity) amplifiers can be used.

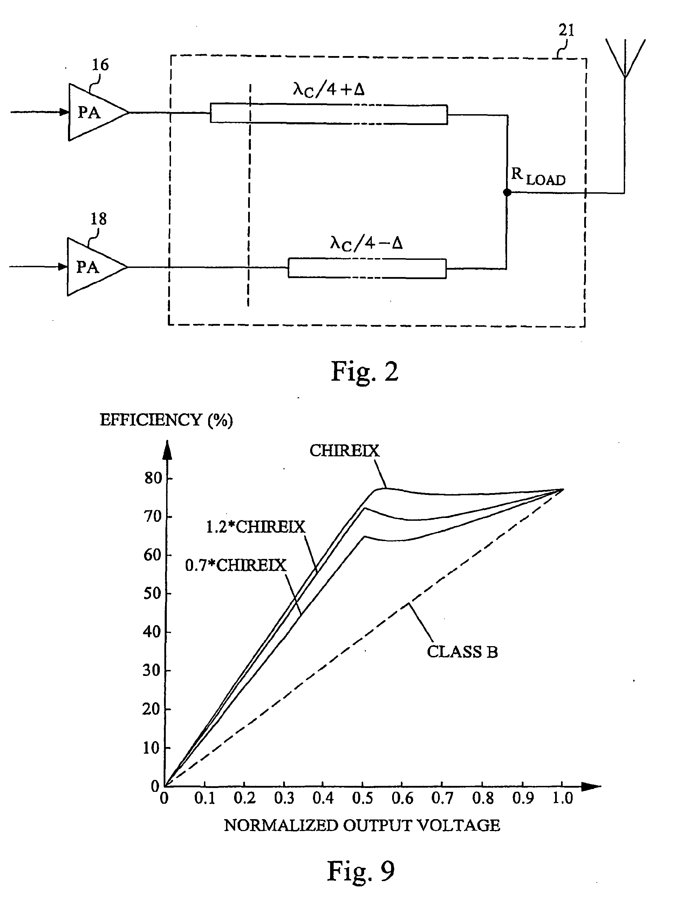

A step towards this new composite amplifier is to alter the structure of the output network of the Chireix amplifier to get rid of the reactances $+jX$ and $-jX$. This can be done by using shortened and lengthened versions of the quarter wavelength lines used in the prior art. The impedance $Z_L$ of these is the optimum load impedance $R_{opt}$ for a class B amplifier, and the load impedance $R_{LOAD}$ should be half this value. The shortened and lengthened (by equal amounts $\Delta$) transmission lines act as quarter wave lines with the appropriate reactances. The new output network structure is illustrated in Fig. 2 as output network 21.

At 2 times the first Chireix operating frequency, there is another Chireix mode. Other relations between the lengths of the lines give rise to other (sometimes useful) patterns of modes. Of course, the different modes can also be placed at the same frequency, by changing the physical lengths of the transmission lines.

The Chireix amplifier drive signals from signal component separator 10 in Fig, 1 include a linear plus or minus a nonlinear component (plus to one power amplifier and minus to the other power amplifier). These components are illustrated in Fig, 3. By separating each constant-amplitude phase-modulated signal from a standard signal component separator 10 into a linear part and a modified nonlinear part, changing the amplitude and phase of these components individually according to a set of specific rules, and recombining the parts into a signal with new properties, it is possible to obtain a Chireix type amplifier with substantially lower drive power consumption than the standard Chireix amplifier.

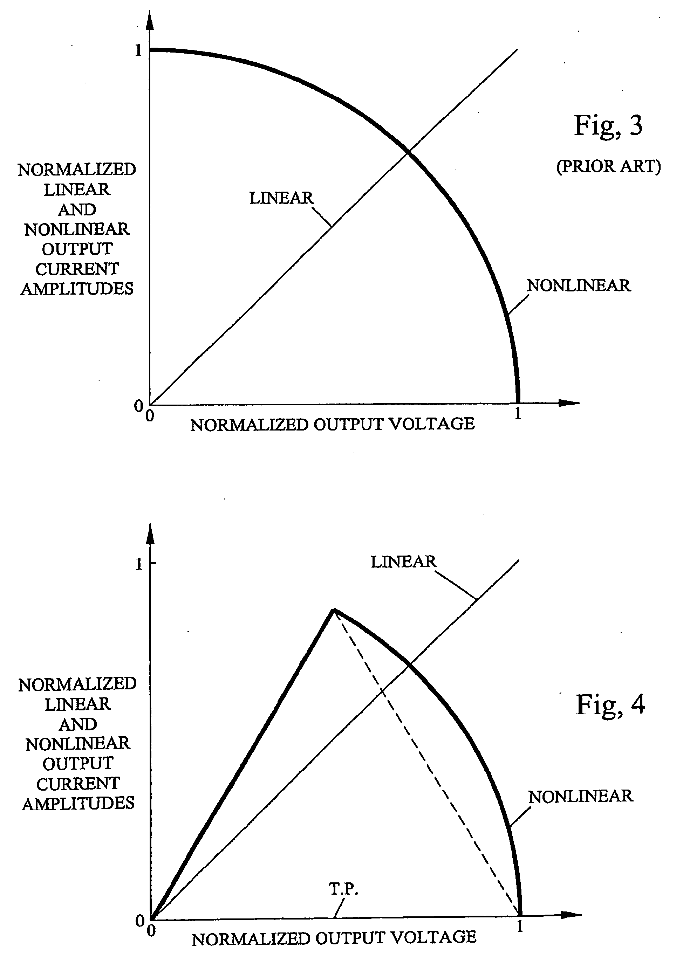

Fig. 4 is a diagram similar to Fig. 3 illustrating the modification in accordance with the present invention. The basic idea of the modification is to drive the composite amplifier linearly below a certain transition point T.P. In an ordinary Chireix amplifier the amplitude of the drive signal is constant, and the phase difference between the amplifiers is used to generate amplitude modulation at the output. Below the transition point this leads to excessive current consumption, because the voltage and current at each power amplifier will become more and more out of phase. The output power decreases but the transistor RF current (which can be translated to DC current) will not decrease. Thus, at some point (defined below) it is better to decrease the drive, and keep the phase difference constant, instead of continuing with outphasing action.

In order to generate the drive signals, it is first necessary to calculate the transition point where the amplifier should go from outphasing to linear operation. This point can easily be identified in a Chireix amplifier current plot (or a plot of amplifier efficiency) as the point where a straight line through the origin touches the current curve. It is also possible to calculate the point analytically.

It is also possible to use a linear approximation of the circle segment, as indicated by the dashed line in Fig. 4, without loosing much efficiency. Below the transition point the phase difference between the drive signals is kept constant, and the amplitude is decreased linearly toward zero in order to maximize efficiency.

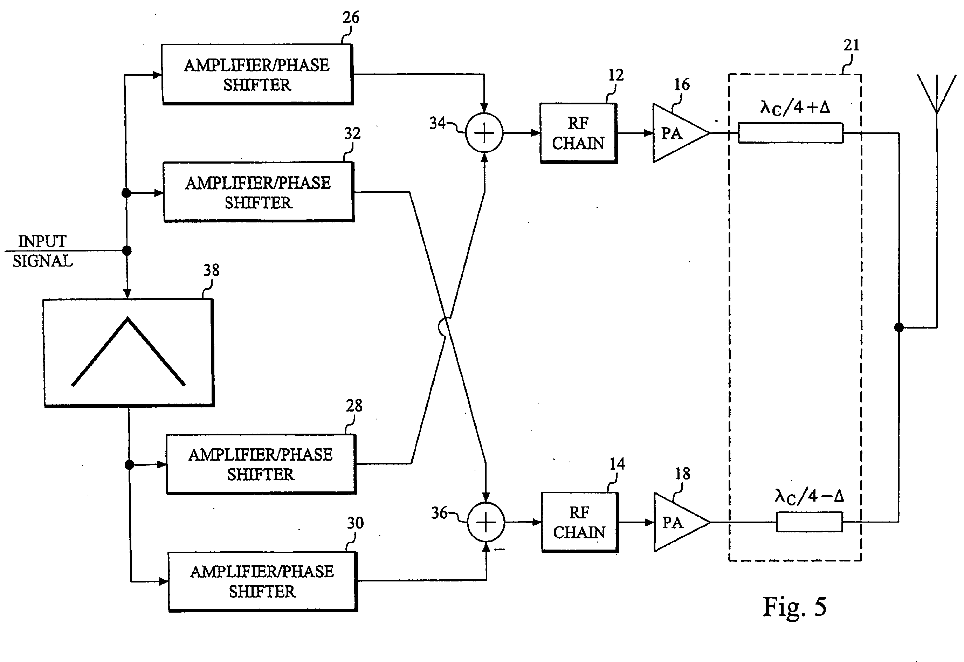

Fig. 5 is a block diagram of an exemplary embodiment of a Chireix amplifier in accordance with the present invention. The linear drive signal components are produced by amplifier/phase shifter 26 and 32 directly from the input signal. Similarly, nonlinear drive signal components are generated by a nonlinear element 38 and amplifier/phase shifter 28 and 30. The amplitude dependence is linear up to the transition point T.P., and follows a linear approximation of the circle segment after the transition point. Unit 38 may, for example, be implemented as a combination of a lookup table followed by D/A converters in which a digital input signal amplitude is transformed into the proper drive signals (the input signal amplitude is assumed to be proportional to the composite amplifier output voltage amplitude). However, analog implementations are also possible. The nonlinear signal from amplifier/phase shifter 28 is added to the linear signal component from amplifier/phase shifter 26 in an adder 34, while the nonlinear signal from amplifier/phase shifter 30 is subtracted from the linear signal component from amplifier/phase shifter 32 in an adder 36. In an analog embodiment adders 34, 36 may, for example, be realized as hybrids. In a digital embodiment they are digital adders. As indicated by an antenna, the composite amplifier may be part of a transmitter, for example a transmitter in a radio terminal, such as a base station or a mobile station in a cellular mobile radio communication system.

It is appreciated that each of the drive signal components will include a common phase component. For this reason only three of the phases actually have to be adjusted.

A method of adjusting the amplitudes and phases of the linear parts (which does not assume an ideal balanced output network) is to adjust them to obtain maximum power output and maximum efficiency at the maximum input excitation level (with otherwise linear behavior). This can be done in a model of the amplifier, to obtain adjustment factors, or in the amplifier itself. The result of this operation is amplifier performance and efficiency similar to a class-B amplifier using the same transistors.

In this embodiment the amplitudes and phases of the nonlinear signal components are adjusted in order to minimize the average current consumption. This condition usually allows at least one of the transistors to have constant and maximum output voltage. Since this procedure should preferably be performed while ensuring linearity in the output, the amplified nonlinear signals should cancel each other at the output. As will be shown below, it is possible to achieve such a cancellation. However, in order to explain how this is done, it will be necessary to introduce a model of the output network.

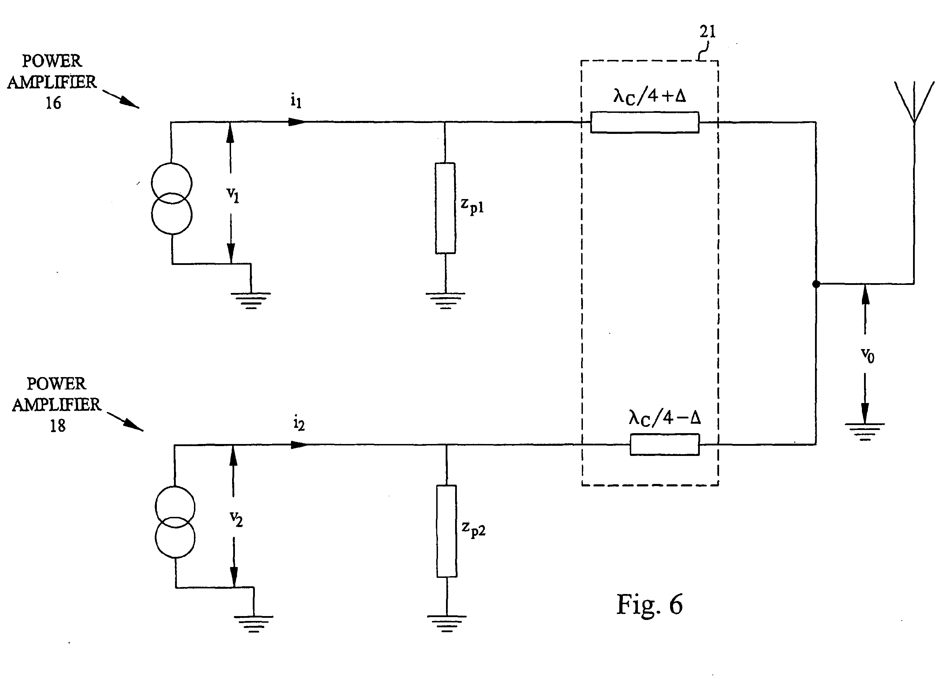

Fig. 6 illustrates such an output network model. In this model the active part of the amplifier transistor outputs are modeled as linear controlled current generators. The finite output conductances of the transistors are denoted $z_{p1}$ and $z_{p2}$, respectively. A quantity of special interest is how RF currents from the output nodes of amplifiers 16 and 18 transform into voltages at the output node of the composite amplifier. This quantity is represented by the output transimpedances

$$z_{o2} = \left.\frac{v_0}{i_2}\right|_{i_1 = 0} \qquad\qquad z_{o1} = \left.\frac{v_0}{i_1}\right|_{i_2 = 0}$$

Assuming that all components are reasonably linear, superposition can be used for analyzing this model.

Since the output network (including combiner 21 and input lines to this combiner) may be unbalanced, it follows that $z_{o1}$ may be different from $z_{o2}$. Since the nonlinear signal parts should cancel each other at the output, it is required that the linearity condition

$$q_1 \cdot z_{o1} + q_2 \cdot z_{o2} = 0 \qquad\qquad\qquad (1)$$

is fulfilled, where $q_1$ and $q_2$ are the adjusted nonlinear components. The condition is possible since the nonlinear parts are identical, except for the sign (thus, it is possible to replace elements 28, 30 by a single amplifier/phase shifter 28). A simple way to fulfil this condition is have a compensating filter in one of the nonlinear branches, for example $z_{o1} * z_{o2}^{-1}$ in the lower branch (here "*" denotes convolution in the time domain and multiplication in the frequency domain). By inserting wideband, frequency-dependent transimpedances $z_{o1}$ and $z_{o2}$ into the linearity condition, linearity in the output is obtained over a wide bandwidth. Thus the nonlinear part will cancel in the output for all frequencies within some specified bandwidth.

Another way to fulfill condition (1) is to insert the filter $z_{o2}$ in the upper branch and the filter $z_{o1}$ in the lower branch. In this way both branches will be subjected to the composite filter $z_{o1} * z_{o2}$.

When the triangular (or partially curved or partially monotonically decreasing) nonlinear "basis function" is used, the linear operation up to the maximum amplitude in the output is obtained by application of the linear basis function alone. When only the linear basis function is present, all RF voltages in the system are less than or equal to their end values since they depend linearly on this function. The magnitudes and gains of the paths for the linear basis function can then be adjusted for achieving a partial objective, i.e. maximum peak power in the output, without the need for adjusting the paths for the nonlinear (triangular) function. This usually means to adjust for the sum of the peak powers of the individual constituent amplifiers, if the output network is properly designed. The amplifier (without the effect of the triangular basis function) then works as an optimal class B amplifier.

The paths for the nonlinear basis function can be arbitrarily adjusted, without showing in the output, as long as condition (1) is met. An additional requirement is of course that nonlinear effects, such as saturation of the amplifiers, do not come into play in any significant way. The objective here is to minimize the D.C. power (i.e. current) consumption, by setting the right magnitude and phase for the nonlinear basis function paths, under these conditions. This maximizes the efficiency. The RF voltages are generally altered at both of the output amplifiers as a result, but as long as the voltages lie inside the maximum allowed, this has no major consequences. Another parameter that can be adjusted is the transition point T.P. where the output voltage of the triangular basis function has its maximum. This can be used for example if the optimum transition voltage is not known beforehand. In conjunction with this adjustment, an adjustment of the shape of the nonlinear basis function (to a curved shape) can, if necessary, be incorporated.

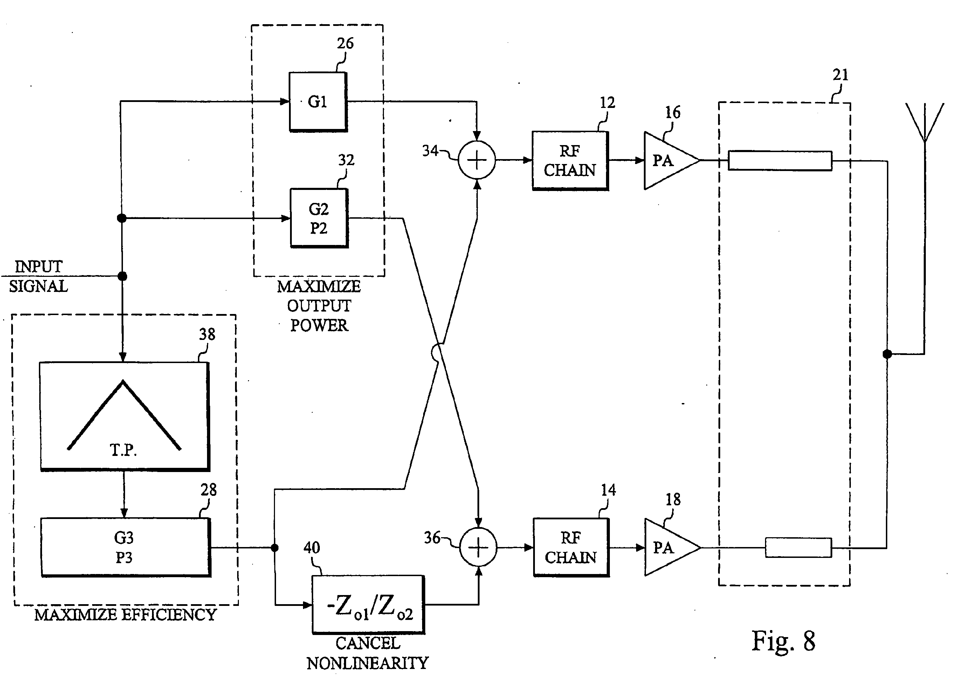

The just described control strategy has the advantages that the peak output power can be independently optimized, and that the efficiency maximization does not affect the output signal. The resulting structure, with provisions for the adjustments, is shown in Fig. 8. The letter G implies a gain, P stands for phase, and T.P. means transition point. The phase of the linear part to one of the amplifiers can (as mentioned above) be left out of the adjustments. These adjustments are for one frequency or operating mode only. If wideband operation is desired, the further methods of [8] can be used.

Although the input network in Fig, 8 is provided before RF chains 12, 14, it is appreciated that the same principles may also be applied anywhere in or after these chains.

It is easy to see that the output network functions as an in-phase combiner, as long as the signals from the two amplifiers are delayed by amounts that compensate for the electrical length difference between the lines leading to the load. This means that it is possible to get linear class B performance from the network at all frequencies. At some (singular) frequencies class B is the best possible operating mode, but at all other frequencies efficiency can be increased by at least some amount compared to class B operation, using the methods proposed above.

The first class B mode, except the trivial one at zero frequency, is found (for the example network with transmission lines having an electrical length of $\lambda_C/3$ and $\lambda_C/6$) at three times the frequency of the first Chireix mode. This means that at all frequencies between these two modes, it is possible to increase efficiency. In practice the possible increase in efficiency is not very great at frequencies close to the class B frequencies. However, for the example network, efficiency comparable to the efficiencies at the first pure Chireix modes (at the first Chireix frequency and an octave above) can be obtained all the way from approximately 0.7 to 2.3 times the first Chireix frequency. This is more than a 3-to-1 bandwidth. Efficiency curves, when using the same (triangular) basis function, for the Chireix mode and modes at 0.7 times and 1.2 times the Chireix mode frequencies, are shown in Fig. 9. For comparison, the efficiency of a class-B amplifier has also been indicated by a dashed line.

The description so far has dealt with somewhat idealized output networks. In practice, the harmonics or overtones of the collector (or drain) voltages of the class-B amplifier must be terminated in certain ways, to make full use of the transistors. For example, the first overtone must be terminated by short-circuiting the collector to RF ground at the first overtone frequency. The network that takes care of this is usually bandlimited, both at the useful (fundamental) and terminating (first overtone) frequencies. This means that, in general, we get a continuous band of high-efficiency modes within the bandwidth limits set by the harmonic termination requirements. However, to say that the networks "themselves" can be used in a 3-to-1 bandwidth with the described methods, is the same as to say that the transmission line lengths of the network can be anywhere within a 1-to-3 span when used at a single frequency, as long as the harmonic termination is correct for this frequency. The tolerance requirements can thus be very relaxed.

Pure transmission line ("distributed") implementations of the output networks are presently preferred for achieving a wide useful bandwidth of high-efficiency modes. Output networks for different modes, or bands of modes, can alternatively be implemented with lumped elements or combinations of lumped and distributed elements.

The described control scheme can be used to good effect with all traditional Chireix networks, as well as all mistuned and otherwise badly behaved variants of these. A major part of the hardware can therefore be made independently of what type of output network it is to be used with. This means that a common flexible amplifier "platform" can be built, from which different properties can be obtained by small changes in the output network. It is easy to change between different Chireix output networks, and optimized output networks for different peak-to-average power ratios can be interchanged without modifications to the rest of the hardware.

Possible mistuning of the output network is of minor consequence, and last-minute changes are not very hazardous. The proposed networks themselves are also highly robust against mistuning, since a very wide band of high efficiency operation can be achieved. If variants of an amplifier for different systems are still needed, they can be built for very little extra cost. Operation of the amplifier in multiple bands, within the limits set by the requirement for harmonic termination, can easily be achieved.

In summary, the proposed output networks enable production of efficient, robust amplifiers without much need for trimming and provide multi-band operation and new, useful high-efficiency modes. Although the described modified output network is preferably used in a composite amplifier that also has the described modified input network, this modified output network is in itself an improvement also in a pure Chireix type of amplifier, since it eliminates the need for the reactances used in prior art Chireix amplifiers.

It will be understood by those skilled in the art that various modifications and changes may be made to the present invention without departure from the scope thereof, which is defined by the appended claims.

REFERENCES

[1] H. Chireix, "High Power Outphasing Modulation", Proc. IRE, vol. 23, no. 2, pp. 1370-1392, Nov. 1935.

[2] W. H. Doherty, "A New High Efficiency Power Amplifier for Modulated Waves", Proc. IRE, vol. 24, no. 9, pp. 1163-1182, Sept. 1936.

[3] F. H. Raab, "Efficiency of Outphasing RF Power Amplifier Systems", IEEE Trans. Communications, vol. COM-33, no. 10, pp. 1094-1099, Oct. 1985.

[4] B. Stengel and W. R. Eisenstadt, "LINC Power Amplifier Combiner Method Efficiency Optimization", IEEE Trans. Vehicular Technology, vol. 49, no. 1, pp. 229-234, Jan. 2000.

[5] X. Zhang and L. E. Larson, "Gain and Phase Error-Free LINC Transmitter", IEEE Trans. Vehicular Technology, vol. 49, no. 5, pp. 1986-1994, Sept. 2000.

[6] A. S. Wright, S. J. Bennett, US Patent 6,054,896.

[7] R. E. Stengel, S. A. Olson, US Patent 5,901,346.

[8] WO 02/05421 A1, Telefonaktiebolaget LM Ericsson.

## Claims

1. Chireix type composite power amplifier including a first and a second power amplifier (16, 18) connected to a common load over an output network, **characterized by**
different length transmission lines in said output network (21) for generating different phase shifts from each power amplifier output to said load.

## Patentansprüche

1. Zusammengesetzter Leistungsverstärker in Chireix-Ausführung, enthaltend einen ersten und einen zweiten Leistungsverstärker (16, 18), die über ein Ausgangsnetzwerk mit einer gemeinsamen Last verbunden sind, **gekennzeichnet durch**
Übertragungsleitungen verschiedener Länge in dem Ausgangsnetzwerk (21) zum Erzeugen verschiedener Phasenverschiebungen von jedem Leistungsverstärkerausgang zu der Last.

## Revendications

1. Amplificateur de puissance composite de type Chireix comprenant des premier et deuxième amplificateurs de puissance (16, 18) connectés à une charge commune sur un réseau de sortie, **caractérisé par**
des lignes de transmission de différentes longueurs dans ledit réseau de sortie (21) pour générer différents déphasages de chaque sortie d'amplificateur de puissance à ladite charge.

Fig. 1

(PRIOR ART

EP 1 583 228 B1

$\lambda_C/4+\Delta$

$R_{LOAD}$

$\lambda_C/4-\Delta$

Fig. 2

EFFICIENCY (%)

CHIREIX

80

70

1.2*CHIREIX

60

0.7*CHIREIX

50

CLASS B

40

30

20

10

0
0   0.1   0.2   0.3   0.4   0.5   0.6   0.7   0.8   0.9   1.0

NORMALIZED OUTPUT VOLTAGE

Fig. 9

NORMALIZED
LINEAR
AND
NONLINEAR
OUTPUT
CURRENT
AMPLITUDES

LINEAR

NONLINEAR

Fig, 3

(PRIOR ART)

NORMALIZED OUTPUT VOLTAGE

NORMALIZED
LINEAR
AND
NONLINEAR
OUTPUT
CURRENT
AMPLITUDES

LINEAR

Fig, 4

NONLINEAR

T.P.

NORMALIZED OUTPUT VOLTAGE

Fig. 5

POWER
AMPLIFIER
16

$v_1$

$i_1$

$z_{p1}$

21

$\lambda_C/4 + \Delta$

$\lambda_C/4 - \Delta$

$v_0$

POWER
AMPLIFIER
18

$v_2$

$i_2$

$z_{p2}$

Fig. 6

EP 1 583 228 B1

Fig. 7

EP 1 583 228 B1

Fig. 8

EP 1 583 228 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 6054896 A, A. S. Wright, S. J. Bennett
- US 5901346 A, R. E. Stengel, S. A. Olson
- WO 0205421 A1

### Non-patent literature cited in the description

- **H. Chireix.** High Power Outphasing Modulation. *Proc. IRE,* November 1935, vol. 23 (2), 1370-1392
- **W. H. Doherty.** A New High Efficiency Power Amplifier for Modulated Waves. *Proc. IRE,* September 1936, vol. 24 (9), 1163-1182
- **F. H. Raab.** Efficiency of Outphasing RF Power Amplifier Systems. *IEEE Trans. Communications,* October 1985, vol. 10, 1094-1099
- **B. Stengel ; W. R. Eisenstadt.** LINC Power Amplifier Combiner Method Efficiency Optimization. *IEEE Trans. Vehicular Technology,* January 2000, vol. 49 (1), 229-234
- **X. Zhang ; L. E. Larson.** Gain and Phase Error-Free LINC Transmitter. *IEEE Trans. Vehicular Technology,* September 2000, vol. 49 (5), 1986-1994